# EUROPEAN PATENT APPLICATION

(11) **EP 4 757 549 A1**
(43) Date of publication of application: **10.06.2026**
(21) Application number: 24918936.6
(22) Date of filing: 07.10.2024
(51) Int. Cl.: H10H 29/01, H10H 29/20, H10H 20/851, H10H 20/85

(54) **DISPLAY DEVICE**

(30) Priority: 18.01.2024 KR 20240007777
(71) Applicant: Samsung Display Co., Ltd., Yongin-si, Gyeonggi-do 17113 (KR)
(72) Inventor: BAEK, Moon Jung, Yongin-si, Gyeonggi-do 17113 (KR); NOH, Hyun Woo, Yongin-si, Gyeonggi-do 17113 (KR)
(74) Representative: Walaski, Jan Filip
(86) International application number: PCT/KR2024/015189
(87) International publication number: WO 2025/154902

(57) **Abstract**

A display includes a partition wall structure defining first to third reception spaces; a color conversion layer including first and second color conversion layers disposed in the first and second reception spaces; a scattering layer disposed in the third reception space, and having a thickness less than each of the first and second color conversion layers; a capping layer covering the partition wall structure, the color conversion layer, and the scattering layer; and a color filter layer disposed on the capping layer, and including first, second, and third color filter layers. A first light blocking stack including the first and third color filter layers disposed on the partition wall structure adjacent to the first and third reception spaces. A second light blocking stack including the second and third color filter layers disposed on the partition wall structure adjacent to the second reception space.

## Description

### Technical Field

Various embodiments relate to a display device.

### Background Art

Display devices may include various components to display images. Among various components included in the display devices, any one component (for example, a first component) may be disposed on another component (for example, a second component). In this case, if an upper surface of the first component is not satisfactorily planarized, the reliability of the second component disposed on the first component may be reduced.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### Detailed Description of Invention

### Technical Problem

Various embodiments are directed to a display device with improved reliability.

### Technical Solution

An embodiment may include a display device, including: a partition wall structure that defines a first reception space, a second reception space, and a third reception space, through which an upper surface of a display element layer is exposed; a color conversion layer including a first color conversion layer disposed in the first reception space, and a second color conversion layer disposed in the second reception space; a scattering layer disposed in the third reception space, the scattering layer having a thickness less than each of a thickness of the first color conversion layer and a thickness of the second color conversion layer; a capping layer that covers the partition wall structure, the color conversion layer, and the scattering layer; and a color filter layer disposed on the capping layer, the color filter layer including a first color filter layer overlapping the first reception space, a second color filter layer overlapping the second reception space, and a third color filter layer overlapping the third reception space. A first light blocking stack formed by stacking the first color filter layer and the third color filter layer may be disposed on the partition wall structure adjacent to the first reception space and the third reception space. A second light blocking stack formed by stacking the second color filter layer and the third color filter layer may be disposed on the partition wall structure adjacent to the second reception space.

In an embodiment, the first light blocking stack may not overlap the second color filter layer.

In an embodiment, the second light blocking stack may not overlap the first color filter layer.

In an embodiment, a step may be defined between an upper surface of the scattering layer and an upper surface of the partition wall structure adjacent to the third reception space.

In an embodiment, the step may be about 20% or more and about 60% or less of a thickness of the partition wall structure.

In an embodiment, the display device may further include an overcoating layer that covers the color filter layer.

In an embodiment, in an area that overlaps the third reception space, a groove that is concave in a direction toward the display element layer may be defined in the overcoating layer.

In an embodiment, a depth of the groove may be less than about 0.5 micrometers.

In an embodiment, the thickness of the first color conversion layer and the thickness of the second color conversion layer may be about 85% or more of a thickness of the partition wall structure.

In an embodiment, the capping layer may include a material having a refractive index of about 1.3 or less.

In an embodiment, the first color conversion layer may include a first color conversion particle. The second color conversion layer may include a second color conversion particle. The scattering layer may include a scattering particle.

In an embodiment, the display element layer may include a first light emitting element overlapping the first reception space, a second light emitting element overlapping the second reception space, and a third light emitting element overlapping the third reception space.

An embodiment may provide a display device, including: a partition wall structure that defines a first reception space, a second reception space, and a third reception space, through which an upper surface of a display element layer is exposed; a color conversion layer including a first color conversion layer disposed in the first reception space, and a second color conversion layer disposed in the second reception space; a scattering layer disposed in the third reception space, the scattering layer having a thickness less than each of a thickness of the first color conversion layer and a thickness of the second color conversion layer; a capping layer that covers the partition wall structure, the color conversion layer, and the scattering layer; and a color filter layer disposed on the capping layer, the color filter layer including a first color filter layer overlapping the first reception space, a second color filter layer overlapping the second reception space, and a third color filter layer overlapping the third reception space. A first light blocking stack formed by stacking the first color filter layer, the second color filter layer, and the third color filter layer may be disposed on the partition wall structure adjacent to the first reception space and the second reception space. A second light blocking stack formed by stacking the first color filter layer and the third color filter layer may be disposed on the partition wall structure adjacent to the third reception space.

In an embodiment, the second light blocking stack may not overlap the second color filter layer.

In an embodiment, a step may be defined between an upper surface of the scattering layer and an upper surface of the partition wall structure adjacent to the third reception space.

In an embodiment, the step may be about 20% or more and about 60% or less of a thickness of the partition wall structure.

In an embodiment, the display device may further include an overcoating layer that covers the color filter layer.

In an embodiment, in an area that overlaps the third reception space, a groove that is concave in a direction toward the display element layer may be defined in the overcoating layer.

In an embodiment, a depth of the groove may be less than about 0.5 micrometers.

In an embodiment, the thickness of the first color conversion layer and the thickness of the second color conversion layer may be about 85% or more of a thickness of the partition wall structure.

In an embodiment, the capping layer may include a material having a refractive index of about 1.3 or less.

In an embodiment, in an area that overlaps the partition wall structure disposed between the first reception space and the third reception space, the surface area of an area where the second light blocking stack is disposed may be greater than the surface area of an area where the first light blocking stack is disposed in a cross-sectional view.

In an embodiment, in an area that overlaps the partition wall structure disposed between the second reception space and the third reception space, the surface area of an area where the second light blocking stack is disposed may be greater than the surface area of an area where the first light blocking stack is disposed in a cross-sectional view.

### Advantageous Effects

A display device in accordance with embodiments may include: a partition wall structure formed to define first to third reception spaces through which an upper surface of a display element layer is exposed; a color conversion layer including a first color conversion layer disposed in the first reception space, and a second color conversion layer disposed in the second reception space; a scattering layer disposed in the third reception space, and having a thickness less than each of a thickness of the first color conversion layer and a thickness of the second color conversion layer; a capping layer that covers the partition wall structure, the color conversion layer, and the scattering layer; and a color filter layer disposed on the capping layer, and including a first color filter layer overlapping the first reception space, a second color filter layer overlapping the second reception space, and a third color filter layer overlapping the third reception space.

A light blocking stack formed by stacking the first color filter layer and the third color filter layer is disposed on the partition wall structure adjacent to the third reception space. As such, since the light blocking stack including only two color filters is disposed on the partition wall structure adjacent to the third reception space, a problem of reliability deterioration due to a step defined by the scattering layer having a relatively small thickness may be prevented from occurring.

### Description of Drawings

The above and other aspects and features of the disclosure will become more apparent by describing in detail embodiments thereof with reference to the attached drawings, in which:
FIG. 1 is a block diagram for describing a display device in accordance with embodiments.
FIG. 2 is a block diagram for describing any one sub-pixel among sub-pixels included in a display device of FIG. 1.
FIG. 3 is a schematic plan view for describing a display panel provided to constitute the display device of FIG. 1.
FIG. 4 is a schematic sectional view for describing the display panel of FIG. 3.
FIG. 5 is a schematic plan view for describing an embodiment of any one pixel among pixels included in the display panel of FIG. 3.
FIGS. 6 to 8 are schematic plan views for describing a color filter layer included in the pixel of FIG. 5.
FIG. 9 is a schematic sectional view taken along line X1-X1' of FIG. 5.
FIG. 10 is a schematic sectional view for describing an embodiment of a capping layer included in the pixel of FIG. 9.
FIG. 11 is a schematic plan view for describing an embodiment of a capping layer included in the pixel of FIG. 9.
FIG. 12 is a schematic plan view for describing an embodiment of any one pixel among the pixels included in the display panel of FIG. 3.
FIGS. 13 to 15 are schematic plan views for describing a color filter layer included in the pixel of FIG. 12.
FIG. 16 is a schematic sectional view taken along line X2-X2' of FIG. 12.

### Modes of the Invention

Hereinafter, an embodiment will be described in detail with reference to the attached drawings. In the following description, parts required for understanding of the disclosure will be described, and explanation of the other parts may be omitted. Accordingly, the disclosure is not limited to the embodiments set forth herein but may be embodied in other types. Rather, these embodiments are provided so that the disclosure will be thorough and complete, and will fully convey the technical spirit of the disclosure to those skilled in the art.

It will be understood that when an element is referred to as being "coupled" or "connected" to another element, it can be directly coupled or connected to the other element or indirectly coupled or connected to the other element with intervening elements therebetween.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

The terminology used herein is for the purpose of describing particular embodiments only and is not intended to be limiting.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Spatially relative terms, such as "beneath," "below," "under," "lower," "above," "upper," "over," "higher," "side" (for example, as in "sidewall"), and the like, may be used herein for descriptive purposes, and, thereby, to describe one element or feature's relationship to another element(s) or feature(s), as illustrated in the drawings. Spatially relative terms are intended to encompass different orientations of an apparatus in use, operation, and/or manufacture in addition to the orientation depicted in the drawings. For example, if the device in the drawings is turned upside down, elements described as "below" or "beneath" other elements or features would be oriented "above" the other elements or features. Thus, the term "below" can encompass both an orientation of above and below. Furthermore, the device may be otherwise oriented (for example, rotated 90 degrees or at other orientations), and, as such, the spatially relative descriptors used herein interpreted accordingly.

Various embodiments will be described with reference to diagrams illustrating idealized embodiments. As such, variations from the shapes of the illustrations as a result, for example, of manufacturing techniques and/or tolerances, are to be expected. Therefore, embodiments disclosed herein should not be construed as limited to the particular illustrated shapes of regions, but are to include deviations in shapes that result from, for instance, manufacturing. As such, the shapes illustrated in the drawings may not illustrate the actual shapes of regions of a device, and, as such, are not intended to be limiting.

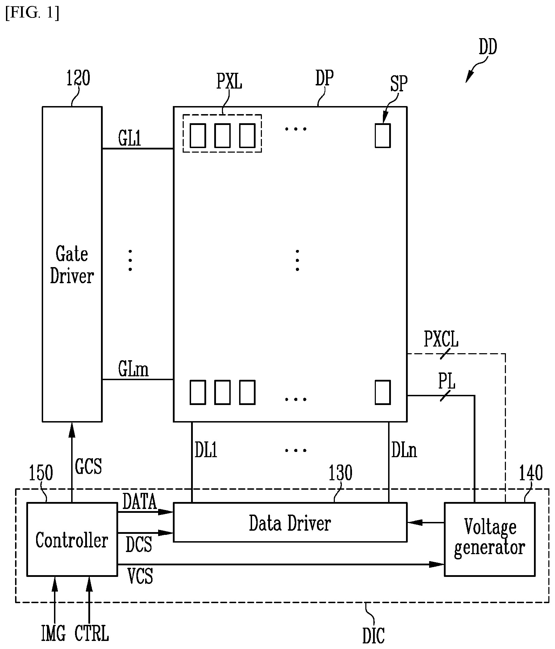

FIG. 1 is a block diagram for describing a display device in accordance with embodiments.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate light in two or more colors. For example, each of the sub-pixels SP may generate light in a color such as red, green, blue, cyan, magenta, or yellow.

Two or more sub-pixels among the sub-pixels SP may form one pixel PXL. For example, the pixel PXL may include three sub-pixels, as illustrated in FIG. 1. The pixel PXL may emit light of various colors and various luminances depending on the combination of light emitted from the sub-pixels included in the pixel PXL.

The gate driver 120 may be connected to sub-pixels SP arranged in a row direction through first to m-th gate lines GL1 to GLm. The gate driver 120 may output gate signals to the first to m-th gate lines GL1 to GLm in response to a gate control signal GCS. In embodiments, the gate control signal GCS may include a start signal instructing each frame to start, a horizontal synchronization signal, and the like within the spirit and the scope of the disclosure.

The gate driver 120 may be disposed on a first side of the display panel DP. However, embodiments are not limited to the aforementioned example. For example, the gate driver 120 may be divided into two or more drivers that are physically and/or logically distinguished from each other. The drivers may be disposed on the first side of the display panel DP and a second side thereof opposite to the first side. As such, the gate driver 120 may be disposed around the display panel DP in various forms depending on the embodiments.

The data driver 130 may be connected to sub-pixels SP arranged in a column direction through the first to n-th data lines DL1 to DLn. The data driver 130 may receive image data DATA and a data control signal DCS from the controller 150. The data driver 130 may operate in response to the data control signal DCS. In embodiments, the data control signal DCS may include a source start signal, a source shift clock, a source output enable signal, and the like within the spirit and the scope of the disclosure.

The data driver 130 may receive voltages from the voltage generator 140. The data driver 130 may apply, using received voltages, data signals having grayscale voltages corresponding to the image data DATA to the first to n-th data lines DL1 to DLn. In case that a gate signal is applied to each of the first to m-th gate lines GL1 to GLm, data signals corresponding to the image data DATA may be applied to the data lines DL1 to DLm. Hence, the sub-pixels SP may generate light corresponding to the data signals, and the display panel DP may display an image.

In embodiments, the gate driver 120 and the data driver 130 may include complementary metal-oxide semiconductor (CMOS) circuit elements.

The voltage generator 140 may operate in response to a voltage control signal VCS provided from the controller 150. The voltage generator 140 may generate voltages and provide the generated voltages to components of the display device DD such as the gate driver 120, the data driver 130, and the controller 150. The voltage generator 140 may receive an input voltage from an external device of the display device DD and generate voltages by regulating the received voltage.

The voltage generator 140 may generate a first power voltage and a second power voltage. The generated first and second power voltages may be provided to the sub-pixels SP through power lines PL. In an embodiment, at least one of the first and second power voltages may be provided from an external device of the display device DD.

The voltage generator 140 may provide various voltages and/or signals. For example, the voltage generator 140 may provide one or more initialization voltages to be applied to the sub-pixels SP. For example, during a sensing operation for sensing electrical characteristics of transistors and/or light emitting elements of the sub-pixels SP, a selectable reference voltage may be applied to each of the first to n-th data lines DL1 to DLn. The voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide pixel control signals to the sub-pixels SP through pixel control lines PXCL. Although in FIG. 1 there is illustrated the case where the pixel control lines PXCL are connected between the voltage generator 140 and the display panel DP, embodiments are not limited thereto. For example, the pixel control lines PXCL may be connected between the gate driver 120 and the display panel DP. In this case, the pixel control signals may be transmitted from the gate driver 120 to the sub-pixels SP through the pixel control lines PXCL.

The controller 150 may control overall operations of the display device DD. The controller 150 may receive input image data IMG and a control signal CTRL corresponding thereto from an external device. The controller 150 may provide a gate control signal GCS, a data control signal DCS, and a voltage control signal VCS, in response to the control signal CTRL.

The controller 150 may convert the input image data IMG to be suitable for the display device DD or the display panel DP and output image data DATA. In embodiments, the controller 150 may align the input image data IMG to be suitable for the sub-pixels SP on a row basis and output the image data DATA.

Two or more components of the data driver 130, the voltage generator 140, and the controller 150 may be mounted on a single integrated circuit. As illustrated in FIG. 1, the data driver 130, the voltage generator 140, and the controller 150 may be included in a driver integrated circuit DIC. In this case, the data driver 130, the voltage generator 140, and the controller 150 may be components that are functionally separated from each other in the single driver integrated circuit DIC. In other embodiments, at least one of the data driver 130, the voltage generator 140, and the controller 150 may be provided as a component separated from the driver integrated circuit DIC.

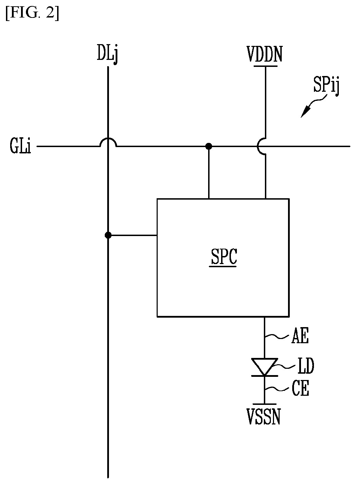

FIG. 2 is a block diagram for describing any one sub-pixel among the sub-pixels included in the display device of FIG. 1. In FIG. 2, there is illustrated a sub-pixel SPij disposed on an i-th row (where i is an integer identical to or greater than 1 and identical to or less than m) and a j-th column (where j is an integer identical to or greater than 1 and identical to or less than n) among the sub-pixels SP of FIG. 1.

Referring to FIG. 2, the sub-pixel SPij may include a sub-pixel circuit SPC and a light emitting element LD.

The light emitting element LD is connected between a first power voltage node VDDN and a second power voltage node VSSN. The first power voltage node VDDN may be connected to one of the power lines PL of FIG. 1 to receive a first power voltage. The second power voltage node VSSN may be connected to another one of the power lines PL of FIG. 1 to receive a second power voltage. The first power voltage may have a voltage level higher than the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD emits light based on current flowing from the anode electrode AE to the cathode electrode CE.

The sub-pixel circuit SPC may be connected both to the i-th gate line GLi among the first to m-th gate lines GL1 to GLm of FIG. 1 and to the j-th data line DLj among the first to n-th data lines DL1 to DLn of FIG. 1. In response to a gate signal received through the i-th gate line GLi, the sub-pixel circuit SPC may control the light emitting element LD to emit light based on a data signal received through the j-th data line DLj. In embodiments, the sub-pixel circuit SPC may be further connected to the pixel control lines PXCL of FIG. 1. In this case, the sub-pixel circuit SPC may further control the light emitting element LD in response to pixel control signals received through the pixel control lines PXCL.

For the sake of the aforementioned operations, the sub-pixel circuit SPC may include circuit elements, for example, transistors and one or more capacitors.

The transistors of the sub-pixel circuit SPC may include p-type transistors and/or N-type transistors. In embodiments, the transistors of the sub-pixel circuit SPC may include a metal oxide semiconductor field effect transistor (MOSFET). In embodiments, the transistors of the sub-pixel circuit SPC may include an amorphous silicon semiconductor, a monocrystalline silicon semiconductor, a polycrystalline silicon semiconductor, an oxide semiconductor, or the like within the spirit and the scope of the disclosure.

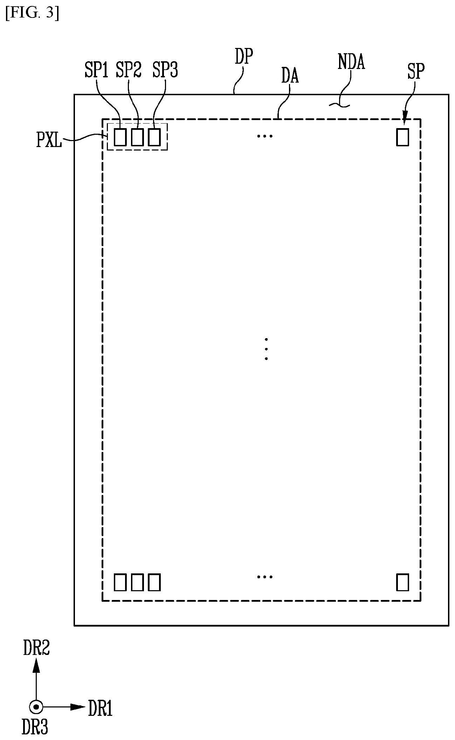

FIG. 3 is a schematic plan view for describing the display panel provided to constitute the display device of FIG. 1.

Referring to FIG. 3, the display panel DP may include a display area DA and a non-display area NDA. The display panel DP may display an image through the display area DA. The non-display area NDA may be disposed around the display area DA.

The display panel DP includes sub-pixels SP disposed in the display area DA. The sub-pixels SP may be arranged in a first direction DR1 and a second direction DR2 intersecting with the first direction DR1. For example, the sub-pixels SP may be arranged in the form of a matrix in the first direction DR1 and the second direction DR2. In another example, the sub-pixels SP may be arranged in a zigzag pattern in the first direction DR1 and the second direction DR2. The arrangement of the sub-pixels SP may be changed depending on the embodiments. The first direction DR1 may refer to a row direction, and the second direction DR2 may refer to a column direction.

Two or more sub-pixels among the sub-pixels SP may form one pixel PXL. Although FIG. 3 illustrates that the pixel PXL includes three sub-pixels SP1, SP2, and SP3, embodiments are not limited thereto. For example, the pixel PXL may include two sub-pixels. Hereinafter, for convenience of explanation, it is assumed that the pixel PXL includes first to third sub-pixels SP1, SP2, and SP3.

Each of the first to third sub-pixels SP1, SP2, and SP3 may generate light of one among various colors such as red, green blue, cyan, magenta, and yellow. Hereinafter, for clear and concise description, it is assumed that the first sub-pixel SP1 generates light in red, the second sub-pixel SP2 generates light in green, and the third sub-pixel SP3 generates light in blue.

Each of the first to third sub-pixels SP1, SP2, and SP3 may include at least one light emitting element that generates light. In embodiments, the light emitting elements of the first to third sub-pixels SP1, SP2, and SP3 may generate light in the same color. For example, the light emitting elements of the first to third sub-pixels SP1, SP2, and SP3 may generate light in blue.

As a display panel DP, a self-luminous display panel such as a light emitting diode (LED) display panel using a micro-scale or nano-scale light emitting diode as a light emitting element, and an organic light emitting display panel (OLED panel) using an organic light emitting diode as a light emitting element may be used.

Components for controlling the sub-pixels SP may be disposed in the non-display area NDA. Lines connected to the sub-pixels SP, for example, the first to m-th gate lines GL1 to GLm, the first to n-th data lines DL1 to DLn, the power lines PL, and the pixel control lines PXCL of FIG. 1, may be disposed in the non-display area NDA.

At least one of the gate driver 120, the data driver 130, the voltage generator 140, and the controller 150 of FIG. 1 may be disposed in the non-display area NDA of the display panel DP. In embodiments, the gate driver 120 may be disposed in the non-display area NDA. In this case, the data driver 130, the voltage generator 140, and the controller 150 may be implemented as the driver integrated circuit DIC of FIG. 1 that is separated from the display panel DP. The driver integrated circuit DIC may be connected to the lines disposed in the non-display area NDA. In other embodiments, the gate driver 120 along with the data driver 130, the voltage generator 140, and the controller 150 may be implemented as a single integrated circuit that is separated from the display panel DP.

In embodiments, the display area DA may have various shapes. The display area DA may have a closed-loop shape, including linear and/or curved sides. For example, the display area DA may have shapes such as polygons, circles, semicircles, ellipses, and the like within the spirit and the scope of the disclosure.

In embodiments, the display panel DP may have a planar display surface. In embodiments, the display panel DP may have a display surface that is at least partially rounded. In embodiments, the display panel DP is bendable, foldable, or rollable. In the aforementioned cases, the display panel DP and/or a substrate of the display panel DP may include materials having flexible properties.

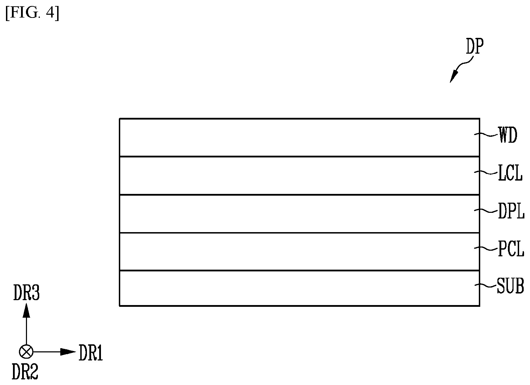

FIG. 4 is a schematic sectional view for describing the display panel of FIG. 3.

Referring to FIG. 4, the display panel DP may include a substrate SUB, and a pixel circuit layer PCL, a display panel layer DPL, a light conversion layer LCL, and a window WD that are sequentially stacked on the substrate SUB in a third direction DR3 intersecting with the first and second directions DR1 and DR2.

The substrate SUB may be made of insulating material such as glass or resin. For example, the substrate SUB may include a glass substrate. In another example, the substrate SUB may include a polyimide (PI) substrate. In another example, the substrate SUB may include a silicon wafer substrate formed through a semiconductor process.

In embodiments, the substrate SUB may be made of material having flexibility so as to be bendable or foldable, and may have a single-layer structure or a multilayer structure. For instance, examples of the material having flexibility may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, embodiments are not limited thereto.

The pixel circuit layer PCL may be disposed on the substrate SUB. The pixel circuit layer PCL may include insulating layers, and semiconductor patterns and conductive patterns disposed between the insulating layers. The conductive patterns of the pixel circuit layer PCL may function as circuit elements, lines, or the like within the spirit and the scope of the disclosure.

The circuit elements of the pixel circuit layers PCL may include the respective sub-pixel circuits (SPC of FIG. 2) of the sub-pixels SP of FIG. 3. In other words, the circuit elements of the pixel circuit layer PCL may be provided as the transistors and one or more capacitors of the sub-pixel circuit SPC.

The lines of the pixel circuit layer PCL may include lines connected to each of the sub-pixels SP. The lines of the pixel circuit layer PCL may include various signal lines and/or voltage lines needed to drive the display element layer DPL.

The display element layer DPL may be disposed on the pixel circuit layer PCL. The display element layer DPL may include light emitting elements of the sub-pixels SP.

The light conversion layer LCL may be disposed on the display element layer DPL. The light conversion layer LCL may include light conversion patterns having color conversion particles and/or scattering particles. For example, the color conversion particles may include quantum dots. The quantum dots may convert the wavelength (or color) of light emitted from the display element layer DPL. In embodiments, the light conversion patterns may be omitted. The light conversion layer LCL may further include a color filter layer including color filters. Each of the color filters may selectively transmit light of a selectable wavelength (or selectable color).

The window WD may be provided on the light conversion layer LCL to protect an exposed surface (or upper surface) of the display panel DP. The window WD may protect the display panel DP from an external impact. The window WD may be bonded to the light conversion layer LCL by an optically transparent adhesive (or bonding) agent. The window WD may have a multilayer structure selected from among a glass substrate, a plastic film, and a plastic substrate. The multilayer structure may be formed through a successive process or an adhesion process using an adhesive layer. The entirety or portion of the window WD may have flexibility.

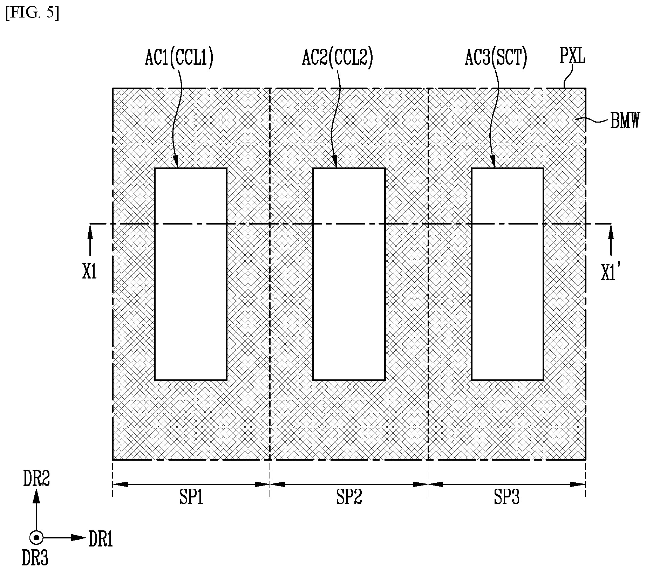

FIG. 5 is a schematic plan view for describing an embodiment of any one of the pixels included in the display panel of FIG. 3.

Referring to FIG. 5, a pixel PXL may include first to third sub-pixels SP1, SP2, and SP3. The first and third sub-pixels SP1, SP2, and SP3 may be arranged in the first direction DR1. However, embodiments are not limited to the aforementioned example. The arrangement of the first to third sub-pixels SP1, SP2, and SP3 may be changed depending on the embodiments.

A partition wall structure BMW may be provided in the first to third sub-pixels SP1, SP2, and SP3. The partition wall structure BMW may define a first reception space AC1, a second reception space AC2, and a third reception space AC3.

The first reception space AC1 may overlap a first light emitting element of the first sub-pixel SP1. A first color conversion layer CCL1 may be disposed in the first reception space AC1. Light emitted from the first light emitting element may be visible to a user of the display device DD via the first color conversion layer CCL1. The first color conversion layer CCL1 may include first color conversion particles. The first color conversion particles may convert the color of light emitted from the first light emitting element to red. Consequently, the first sub-pixel SP1 may be provided as a red sub-pixel.

The second reception space AC2 may overlap a second light emitting element of the second sub-pixel SP2. A second color conversion layer CCL2 may be disposed in the second reception space AC2. Light emitted from the second light emitting element may be visible to the user of the display device DD via the second color conversion layer CCL2. The second color conversion layer CCL2 may include second color conversion particles. The second color conversion particles may convert the color of light emitted from the second light emitting element to green. Consequently, the second sub-pixel SP2 may be provided as a green sub-pixel.

The third reception space AC3 may overlap a third light emitting element of the third sub-pixel SP3. A scattering layer SCL may be disposed in the third reception space AC3. Light emitted from the third light emitting element may be visible to the user of the display device DD via the scattering layer SCL. The scattering layer SCL may include scattering particles. The scattering particles may scatter light emitted from the third light emitting element. In embodiments, the third light emitting element may emit blue light. Consequently, the third sub-pixel SP3 may be provided as a blue sub-pixel.

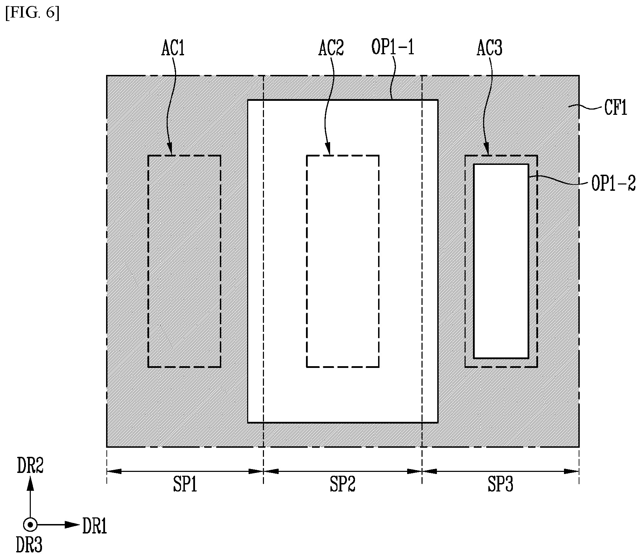

FIGS. 6 to 8 are schematic plan views for describing the color filter layer included in the pixel of FIG. 5.

Referring to FIGS. 5 and 6, a first color filter layer CF1 may be disposed on the partition wall structure BMW.

The first color filter layer CF1 may transmit light having a first wavelength range, and block light having a wavelength other than the first wavelength range. In embodiments, the first color filter layer CF1 may selectively transmit red light. For example, the first color filter layer CF1 may selectively transmit light having a wavelength equal to or greater than about 630 nm and equal to or less than about 780 nm.

As described above, the first sub-pixel SP1 may be provided as a red sub-pixel. In this case, the first color filter layer CF1 may overlap the first reception space AC1. Consequently, in the area where the first sub-pixel SP1 is provided, only red light may pass through the first color filter layer CF1 and be visible to the user of the display device DD.

The first color filter layer CF1 may define a 1-1-th opening OP1-1. The 1-1-th opening OP1-1 may overlap the second reception space AC2. Therefore, light emitted from the second light emitting element of the second sub-pixel SP2 may not be substantially blocked by the first color filter layer CF1. In embodiments, a perimeter of the 1-1-th opening OP1-1 may enclose a perimeter of the second reception space AC2. In this case, the 1-1-th opening OP1-1 may partially overlap not only the second sub-pixel SP2 but also other sub-pixels (for example, the first sub-pixel SP1 and the third sub-pixel SP3) adjacent to the second sub-pixel SP2.

The first color filter layer CF1 may define a 1-2-th opening OP1-2. The 1-2-th opening OP1-2 may overlap the third reception space AC3. Therefore, light emitted from the third light emitting element of the third sub-pixel SP3 may not be substantially blocked by the first color filter layer CF1. In embodiments, a perimeter of the 1-2-th opening OP1-2 may be enclosed by a perimeter of the third reception space AC3.

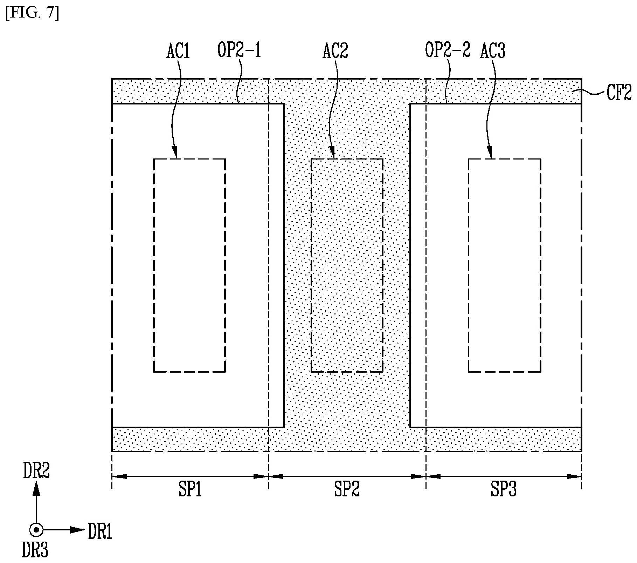

Referring to FIGS. 5 and 7, a second color filter layer CF2 may be disposed on the partition wall structure BMW.

The second color filter layer CF2 may transmit light having a second wavelength range, and block light having a wavelength other than the second wavelength range. In embodiments, the second color filter layer CF2 may selectively transmit green light. For example, the second color filter layer CF2 may selectively transmit light having a wavelength equal to or greater than about 500 nm and equal to or less than about 570 nm.

As described above, the second sub-pixel SP2 may be provided as a green sub-pixel. In this case, the second color filter layer CF2 may overlap the second reception space AC2. Consequently, in the area where the second sub-pixel SP2 is provided, only green light may pass through the second color filter layer CF2 and be visible to the user of the display device DD.

The second color filter layer CF2 may define a 2-1-th opening OP2-1. The 2-1-th opening OP2-1 may overlap the first reception space AC1. Therefore, light emitted from the first light emitting element of the first sub-pixel SP1 may not be substantially blocked by the second color filter layer CF2. In embodiments, a perimeter of the 2-1-th opening OP2-1 may enclose a perimeter of the first reception space AC1. In this case, the 2-1-th opening OP2-1 may partially overlap not only the first sub-pixel SP1 but also other sub-pixels (for example, the second sub-pixel SP2) adjacent to the first sub-pixel SP1.

The second color filter layer CF2 may define a 2-2-th opening OP2-2. The 2-2-th opening OP2-2 may overlap the third reception space AC3. Therefore, light emitted from the third light emitting element of the third sub-pixel SP3 may not be substantially blocked by the second color filter layer CF2. In embodiments, the perimeter of the 2-2-th opening OP2-2 may enclose the perimeter of the third reception space AC3. In this case, the 2-2-th opening OP2-2 may partially overlap not only the third sub-pixel SP3 but also other sub-pixels (for example, the second sub-pixel SP2) adjacent to the third sub-pixel SP3.

In embodiments, in the case where the pixel PXL is arranged in the first direction DR1, the 2-2-th opening OP2-2 defined by the second color filter layer CF2 provided in the pixel PXL may be integral with the 2-1-th opening OP2-1 defined by the second color filter layer CF2 provided in another pixel adjacent to the pixel PXL in the first direction DR1.

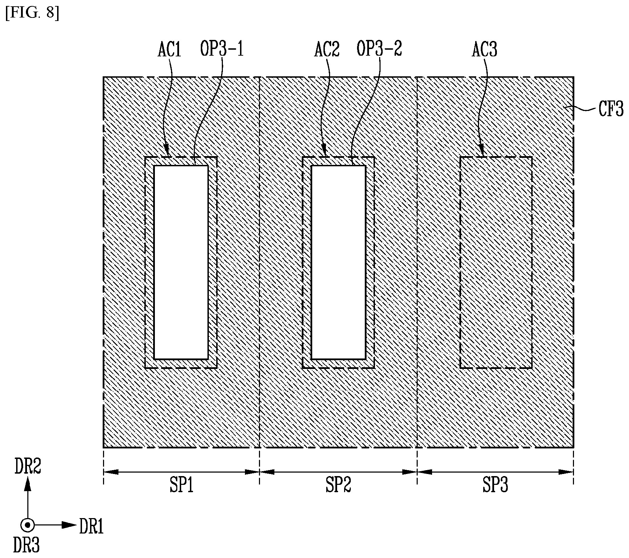

Referring to FIGS. 5 and 8, a third color filter layer CF3 may be disposed on the partition wall structure BMW.

The third color filter layer CF3 may transmit light having a third wavelength range, and block light having a wavelength other than the third wavelength range. In embodiments, the third color filter layer CF3 may selectively transmit blue light. For example, the third color filter layer CF3 may selectively transmit light having a wavelength equal to or greater than about 450 nm and equal to or less than about 495 nm.

As described above, the third sub-pixel SP3 may be provided as a blue sub-pixel. In this case, the third color filter layer CF3 may overlap the third reception space AC3. Consequently, in the area where the third sub-pixel SP3 is provided, only blue light may pass through the third color filter layer CF3 and be visible to the user of the display device DD.

The third color filter layer CF3 may define a 3-1-th opening OP3-1. The 3-1-th opening OP3-1 may overlap the first reception space AC1. Therefore, light emitted from the first light emitting element of the first sub-pixel SP1 may not be substantially blocked by the third color filter layer CF3. In embodiments, a perimeter of the 3-1-th opening OP3-1 may be enclosed by the perimeter of the first reception space AC1.

The third color filter layer CF3 may define a 3-2-th opening OP3-2. The 3-2-th opening OP3-2 may overlap the second reception space AC2. Therefore, light emitted from the second light emitting element of the second sub-pixel SP2 may not be substantially blocked by the third color filter layer CF3. In embodiments, a perimeter of the 3-2-th opening OP3-2 may be enclosed by the perimeter of the second reception space AC2.

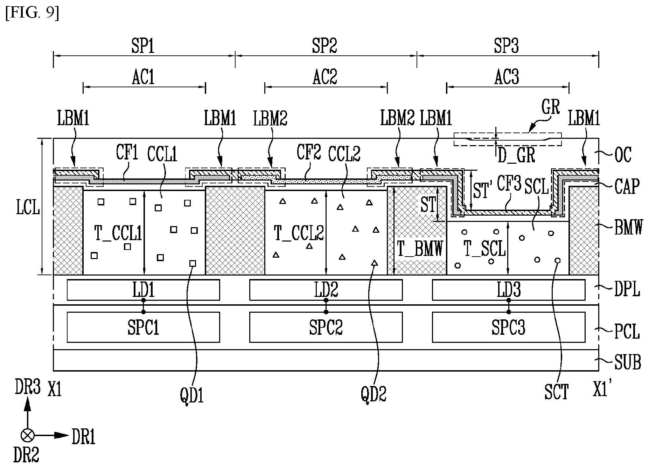

Referring again to FIGS. 5 to 8, the first to third color filter layers CF1, CF2, and CF3 may be sequentially stacked on the partition wall structure BMW. Hereinafter, the first to third color filter layers CF1, CF2, and CF3 that are sequentially stacked on the partition wall structure BMW will be described in more detail with reference to FIG. 9.

FIG. 9 is a schematic sectional view taken along line X1-X1' of FIG. 5.

Referring to FIGS. 5 to 9, the pixel circuit layer PCL, the display element layer DPL, and the light conversion layer LCL may be sequentially disposed on the substrate SUB.

The pixel circuit layer PCL may include insulating layers, semiconductor patterns, and conductive patterns that are stacked on the substrate SUB. The semiconductor patterns and the conductive patterns may be positioned between the insulating layers. The conductive patterns may include at least one of copper (Cu), molybdenum (Mo), tungsten (W), aluminum-neodymium (AINd), titanium (Ti), aluminum (Al), and silver (Ag).

The semiconductor patterns and the conductive patterns included in the pixel circuit layer PCL may function as the transistors and the capacitors of the sub-pixel circuit SPC that have been described with reference to FIG. 2. Furthermore, the semiconductor patterns and the conductive patterns included in the pixel circuit layer PCL may also function as lines, for example, the first to m-th gate lines GL1 to GLm, the first to n-th data lines DL1 to DLn, the power lines PL, and the pixel control lines PXCL of FIG. 1.

The transistors, the capacitors, and the lines included in the pixel circuit layer PCL may define the sub-pixel circuit (SPC of FIG. 2) of each of the first to third sub-pixels SP1, SP2, and SP3. For example, a first sub-pixel circuit SPC1 may be provided in the first sub-pixel SP1. A second sub-pixel circuit SPC2 may be provided in the second sub-pixel SP2. A third sub-pixel circuit SPC3 may be provided in the third sub-pixel SP3.

The display element layer DPL may be disposed on the pixel circuit layer PCL. The display element layer DPL may include the light emitting element (LD of FIG. 2) of each of the first to third sub-pixels SP1, SP2, and SP3. For example, a first light emitting element LD1 may be provided in the first sub-pixel SP1. A second light emitting element LD2 may be provided in the second sub-pixel SP2. A third light emitting element LD3 may be provided in the third sub-pixel SP3.

The first light emitting element LD1 may be electrically connected to the first sub-pixel circuit SPC1. The second light emitting element LD2 may be electrically connected to the second sub-pixel circuit SPC2. The third light emitting element LD3 may be electrically connected to the third sub-pixel circuit SPC3. The first to third light emitting elements LD1, LD2, and LD3 may emit light of luminance corresponding to electrical signals provided from the first to third sub-pixel circuits SPC1, SPC2, and SPC3. In embodiments, the first to third light emitting elements LD1, LD2, and LD3 may emit light in the same color. For example, the first to third light emitting elements LD1, LD2, and LD3 may emit blue light.

The light conversion layer LCL may be disposed on the display element layer DPL. The light conversion layer LCL may include the partition wall structure BMW, the first color conversion layer CCL1, the second color conversion layer CCL2, the scattering layer SCL, the capping layer CAP, the first color filter layer CF1, the second color filter layer CF2, the third color filter layer CF3, and an overcoating layer OC.

The partition wall structure BMW may be disposed on the display element layer DPL. In embodiments, the partition wall structure BMW may be directly disposed on the display element layer DPL. In other words, the partition wall structure BMW may directly contact an upper surface of the display element layer DPL.

The partition wall structure BMW may include light blocking material. Therefore, the partition wall structure BMW may function to prevent light mixture between adjacent sub-pixels. In embodiments, the partition wall structure BMW may include organic insulating material. For example, the partition wall structure BMW may include acryl resin, epoxy resin, phenolic resin, polyamide resin, and/or polyimide resin.

The partition wall structure BMW may define the first to third reception spaces AC1, AC2, and AC3 that expose the upper surface of the display element layer DPL. The first reception space AC1 may overlap the first light emitting element LD1. The second reception space AC2 may overlap the second light emitting element LD2. The third reception space AC3 may overlap the third light emitting element LD3.

The first color conversion layer CCL1 may be disposed in the first reception space AC1. In embodiments, the first color conversion layer CCL1 may be directly disposed on the display element layer DPL. In other words, the first color conversion layer CCL1 may directly contact the upper surface of the display element layer DPL.

The first color conversion layer CCL1 may include first color conversion particles QD1. The first color conversion particles QD1 may change the wavelength of light emitted from the first light emitting element LD1. For example, the first color conversion particles QD1 may convert light emitted from the first light emitting element LD1 into red light. Consequently, the first sub-pixel SP1 may be provided as a red sub-pixel. In embodiments, the first color conversion particles QD1 may be quantum dots. In embodiments, the first color conversion layer CCL1 may further include scattering particles.

The second color conversion layer CCL2 may be disposed in the second reception space AC2. In embodiments, the second color conversion layer CCL2 may be directly disposed on the display element layer DPL. In other words, the second color conversion layer CCL2 may directly contact the upper surface of the display element layer DPL.

The second color conversion layer CCL2 may include second color conversion particles QD2. The second color conversion particles QD2 may change the wavelength of light emitted from the second light emitting element LD2. For example, the second color conversion particles QD2 may convert light emitted from the second light emitting element LD2 into green light. Consequently, the second sub-pixel SP2 may be provided as a green sub-pixel. For example, the second color conversion particles QD2 may be quantum dots. In embodiments, the second color conversion layer CCL2 may further include scattering particles.

The scattering layer SCL may be disposed in the third reception space AC3. In embodiments, the scattering layer SCL may be directly disposed on the display element layer DPL. In other words, the scattering layer SCL may directly contact the upper surface of the display element layer DPL.

The scattering layer SCL may include scattering particles SCT. The scattering particles SCT may scatter light emitted from the third light emitting element LD3 to improve light output efficiency. Hence, in the case where the third light emitting element LD3 emits blue light, the third sub-pixel SP3 may be provided as a blue sub-pixel. In embodiments, the scattering particles SCT may include TiO₂.

In embodiments, the scattering layer SCL may have a relatively small thickness. Each of the first and second color conversion layers CCL1 and CCL2 may have a relatively large thickness. For example, a thickness T_SCL of the scattering layer SCL in the third direction DR3 may be less than a thickness T_CCL1 of the first color conversion layer CCL1 in the third direction DR3 or a thickness T_CCL2 of the second color conversion layer CCL2 in the third direction DR3. In this case, the light output efficiency of the first to third sub-pixels SP1, SP2 and SP3 may be improved.

For example, it may be assumed that a thickness T_BMW of the partition wall structure BMW in the third direction DR3 is about 10 micrometers. In this case, if the thickness T_SCL of the scattering layer SCL is about 8.5 micrometers, the light output efficiency of the third sub-pixel SP3 may be about 100%. Here, in the case where the thickness T_SCL of the scattering layer SCL is about 7.5 micrometers, the light output efficiency of the third sub-pixel SP3 may be improved to about 105%. In the case where the thickness T_SCL of the scattering layer SCL is about 6.5 micrometers, the light output efficiency of the third sub-pixel SP3 may be improved to about 108%. In the case where the thickness T_SCL of the scattering layer SCL is about 5.5 micrometers, the light output efficiency of the third sub-pixel SP3 may be improved to about 113%. In other words, as the thickness of the scattering layer SCL is relatively reduced, the light output efficiency of the third sub-pixel SP3 may be improved.

In another example, it may be assumed that the thickness T_BMW of the partition wall structure BMW in the third direction DR3 is about 10 micrometers. In this case, if the thickness T_CCL1 of the first color conversion layer CCL1 is about 8.5 micrometers, the light output efficiency of the first sub-pixel SP1 may be about 100%. Here, in the case where the thickness T_CCL1 of the first color conversion layer CCL1 is about 7.5 micrometers, the light output efficiency of the first sub-pixel SP1 may be reduced to about 96%. In the case where the thickness T_CCL1 of the first color conversion layer CCL1 is about 6.5 micrometers, the light output efficiency of the first sub-pixel SP1 may be reduced to about 92%. In the case where the thickness T_CCL1 of the first color conversion layer CCL1 is about 5.5 micrometers, the light output efficiency of the first sub-pixel SP1 may be reduced to about 86%. In other words, as the thickness of the first color conversion layer CCL1 is relatively increased, the light output efficiency of the first sub-pixel SP1 may be improved.

In another example, it may be assumed that the thickness T_BMW of the partition wall structure BMW in the third direction DR3 is about 10 micrometers. In this case, if the thickness T_CCL2 of the second color conversion layer CCL2 is about 8.5 micrometers, the light output efficiency of the second sub-pixel SP2 may be about 100%. Here, in the case where the thickness T_CCL2 of the second color conversion layer CCL2 is about 7.5 micrometers, the light output efficiency of the second sub-pixel SP2 may be about 98.5%. In the case where the thickness T_CCL2 of the second color conversion layer CCL2 is about 6.5 micrometers, the light output efficiency of the second sub-pixel SP2 may be about 97%. In the case where the thickness T_CCL2 of the second color conversion layer CCL2 is about 5.5 micrometers, the light output efficiency of the second sub-pixel SP2 may be about 95%. In other words, as the thickness of the second color conversion layer CCL2 is relatively increased, the light output efficiency of the second sub-pixel SP2 may be improved.

As described above, to improve the light output efficiency of each of the first to third sub-pixels SP1, SP2, and SP3, the scattering layer SCL may have a relatively small thickness, and each of the first and second color conversion layers CCL1 and CCL2 may have a relatively large thickness. For example, the thickness T_SCL of the scattering layer SCL may be equal to or greater than about 40% and less than or equal to about 80% of the thickness T_BMW of the partition wall structure BMW. In another example, the thickness T_CCL1 of the first color conversion layer CCL1 and the thickness T_CCL2 of the second color conversion layer CCL2 may each independently be equal to or greater than about 85% of the thickness T_BMW of the partition wall structure BMW.

As the scattering layer SCL has a relatively small thickness, a step ST may be defined between an upper surface of the scattering layer SCL and an upper surface of the partition wall structure BMW adjacent to the third reception space AC3. For example, the step ST may be equal to or greater than about 20% and less than or equal to about 60% of the thickness T_BMW of the partition wall structure BMW.

The capping layer CAP may cover the entireties of the partition wall structure BMW, the first color conversion layer CCL1, the second color conversion layer CCL2, and the scattering layer SCL. The capping layer CAP may function to protect components disposed under or below the capping layer CAP.

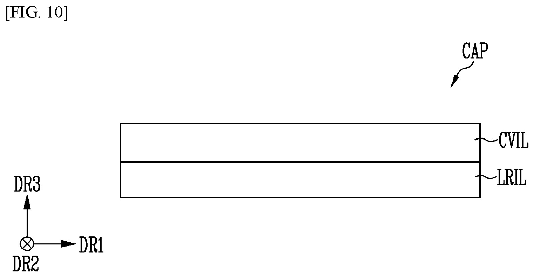

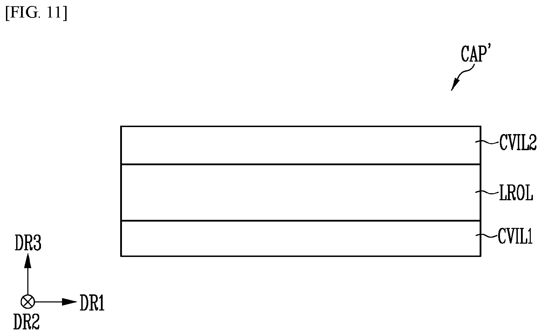

In embodiments, the capping layer CAP may include material having a relatively low refractive index. In this case, the capping layer CAP may refract or totally reflect light depending on an incident angle. For example, the capping layer CAP may provide light passing through the first color conversion layer CCL1 to the first color conversion layer CCL1 again. Hence, the light conversion efficiency of the first color conversion layer CCL1 may be improved. The capping layer CAP will be described later in detail with reference to FIGS. 10 and 11.

In embodiments, the cross-sectional profile of the capping layer CAP may be formed to correspond to the profile of components (for example, the partition wall structure BMW, the first color conversion layer CCL1, the second color conversion layer CCL2, and the scattering layer SCL) disposed under or below the capping layer CAP. For example, the capping layer CAP may extend from the upper surface of the partition wall structure BMW that is adjacent to the third reception space AC3 to the upper surface of the scattering layer SCL disposed in the third reception space AC3. In this case, a step corresponding to the step ST may be defined in the capping layer CAP.

The first to third color filter layers CF1, CF2, and CF3 may be disposed on the capping layer CAP. The openings OP1-1, OP1-2, OP2-1, OP2-2, OP3-1, and OP3-2 described with reference to FIGS. 6 to 8 may be defined in the first to third color filter layers CF1, CF2, and CF3. Hence, in some areas, the first to third color filter layers CF1, CF2, and CF3 may overlap each other. In other some areas, the first to third color filter layers CF1, CF2, and CF3 may not overlap each other. In the case where the first to third color filter layers CF1, CF2, and CF3 overlap each other, the second color filter layer CF2 may be disposed on the first color filter layer CF1, and the third color filter layer CF3 may be disposed on the first and second color filter layers CF1 and CF2.

The first color filter layer CF1 may overlap the first reception space AC1. In this case, the first color filter layer CF1 may extend to above the partition wall structure BMW adjacent to the first reception space AC1. Furthermore, the first color filter layer CF1 may be disposed on the partition wall structure BMW adjacent to the third reception space AC3.

The second color filter layer CF2 may overlap the second reception space AC2. In this case, the second color filter layer CF2 may extend to above the partition wall structure BMW adjacent to the second reception space AC2.

The third color filter layer CF3 may overlap the third reception space AC3. In this case, the third color filter layer CF3 may extend to above the partition wall structure BMW adjacent to the third reception space AC3. Furthermore, the third color filter layer CF3 may be disposed on the partition wall structure BMW adjacent to the first and second reception spaces AC1 and AC2. In this case, the first color filter layer CF1 or the second color filter layer CF2 may be disposed under or below the third color filter layer CF3.

On the partition wall structure BMW adjacent to the first and third reception spaces AC1 and AC3, the first color filter layer CF1 and the third color filter layer CF3 may be sequentially stacked in the third direction DR3, thus defining a first light blocking stack LBM1. The first light blocking stack LBM1 may not overlap the second color filter layer CF2. On the partition wall structure BMW adjacent to the second reception space AC2, the second color filter layer CF2 and the third color filter layer CF3 may be sequentially stacked in the third direction DR3, thus defining a second light blocking stack LBM2. The second light blocking stack LBM2 may not overlap the first color filter layer CF1. As such, two different color filter layers may be stacked, thus defining a light blocking stack for preventing light mixture between adjacent sub-pixels.

In an embodiment, the first light blocking stack LBM1 may extend from above the partition wall structure BMW to above the first color conversion layer CCL1, whereby the first light blocking stack LBM1 may partially overlap the first reception space AC1.

In an embodiment, the second light blocking stack LBM2 may extend from above the partition wall structure BMW to above the second color conversion layer CCL2, whereby the second light blocking stack LBM2 may partially overlap the second reception space AC2.

In an embodiment, the first light blocking stack LBM1 may extend from above the partition wall structure BMW to above the scattering layer SCL, whereby the first light blocking stack LBM1 may partially overlap the third reception space AC3. Therefore, the first light blocking stack LBM1 may cover the step ST defined between the upper surface of the scattering layer SCL and the upper surface of the partition wall structure BMW adjacent to the third reception space AC3.

In embodiments, a step ST' corresponding to the step ST may be defined between an upper surface of the first light blocking stack LBM1 disposed on the partition wall structure BMW adjacent to the third reception space AC3 and an upper surface of the third color filter layer CF3 that overlaps the scattering layer SCL. In the disclosure, the first light blocking stack LBM1 may have a structure in which two color filter layers (for example, the first color filter layer CF1 and the third color filter layer CF3) are stacked. Therefore, compared to the case where the first light blocking stack LBM1 has a structure in which three color filters (for example, the first to third color filter layers CF1, CF2, and CF3) are stacked, the thickness of the first light blocking stack LBM1 in the third direction DR3 may be relatively reduced. Consequently, the step ST' formed to correspond to the step ST may be relatively reduced.

The overcoating layer OC may cover the entireties of the first to third color filter layers CF1, CF2, and CF3. The overcoating layer OC may function to protect components disposed under or below the overcoating layer OC. In embodiments, the overcoating layer OC may include organic insulating material. For example, the overcoating layer OC may include acrylic resin, epoxy resin, phenolic resin, polyamide resin, polyimide resin, unsaturated polyester resin, poly-phenylen ether resin, poly-phenylene sulfide resin, and/or benzocyclobutene resin.

In embodiments, the window WD described with reference to FIG. 4 or a bonding (or adhesive) film formed to provide the window WD may be disposed on the overcoating layer OC. To this end, the overcoating layer OC may be required to have a substantially planar upper surface. For example, the step defined on the upper surface of the overcoating layer OC may be required to be equal to or less than about 0.5 micrometers. If the upper surface of the overcoating layer OC is not substantially planar, bonding defects (or adhesive defects) (for example, formation of air bubbles or the like) may occur between the overcoating layer OC and the window WD or between the overcoating layer OC and the film. In this case, the reliability of the window WD or the film may be reduced.

In an embodiment, in an area that overlaps the third reception space AC3, a groove GR that is concave in a direction toward the display element layer DPL may be defined in the overcoating layer OC. The groove GR may be formed by the step ST' derived from the step ST.

As described above, since the first light blocking stack LBM1 disposed on the partition wall structure BMW adjacent to the third reception space AC3 includes only two color filter layers (for example, the first color filter layer CF1 and the third color filter layer CF3), the step ST' may be relatively reduced. Therefore, a depth D_GR of the groove GR formed by the step ST' may also be relatively reduced. For example, the depth D_GR of the groove GR may be less than about 0.5 micrometers. In this case, the reliability of the window WD or the film disposed on the overcoating layer OC may not be reduced.

Unlike the aforementioned case, if the first light blocking stack LBM1 disposed on the partition wall structure BMW adjacent to the third reception space AC3 is a stack including three color filter layers (for example, the first to third color filter layers CF1, CF2, and CF3), the depth D_GR of the groove GR may be relatively increased. For example, the depth D_GR of the groove GR in the case where the first light blocking stack LBM1 includes three color filter layers may be equal to or greater than about 1.5 times the depth D_GR of the groove GR in the case where the first light blocking stack LBM1 includes two color filter layers. In this case, the reliability of the window WD or the film disposed on the overcoating layer OC may be reduced.

FIG. 10 is a schematic sectional view for describing an embodiment of the capping layer included in the pixel of FIG. 9.

In an embodiment, the capping layer CAP may include a low refractive inorganic layer LRIL. The low refractive inorganic layer LRIL may include inorganic insulating material having a refractive index of 1.3 or less. For example, the low refractive inorganic layer LRIL may include silicon oxide.

In an embodiment, the capping layer CAP may further include a cover inorganic layer CVIL disposed on the low refractive inorganic layer LRIL. The cover inorganic layer CVIL may function to prevent impurities from diffusing from the first to third color filter layers CF1, CF2, and CF3 disposed on the capping layer CAP into the low refractive inorganic layer LRIL. The cover inorganic layer CVIL may include inorganic insulating material having a relatively high refractive index compared to the low refractive inorganic layer LRIL. For example, the cover inorganic layer CVIL may include silicon oxy nitride and/or silicon nitride.

FIG. 11 is a schematic plan view for describing an embodiment of the capping layer included in the pixel of FIG. 9.

In an embodiment, the capping layer CAP' may include a first cover inorganic layer CVIL1, a second cover inorganic layer CVIL2 disposed on the first cover inorganic layer CVIL1, and a low refractive organic layer LROL between the first cover inorganic layer CVIL1 and the second cover inorganic layer CVIL2.

The low refractive organic layer LROL may include organic insulating material having a refractive index of 1.3 or less. The first cover inorganic layer CVIL1 may function to prevent impurities from diffusing from components disposed under or below the low refractive organic layer LROL into the low refractive organic layer LROL. The second cover inorganic layer CVIL2 may function to prevent impurities from diffusing from components disposed over the low refractive organic layer LROL into the low refractive organic layer LROL. The first and second cover inorganic layers CVIL1 and CVIL2 may each independently include inorganic insulating material having a relatively high refractive index. For example, the first and second cover inorganic layers CVIL1 and CVIL2 may each independently include silicon oxynitride and/or silicon nitride.

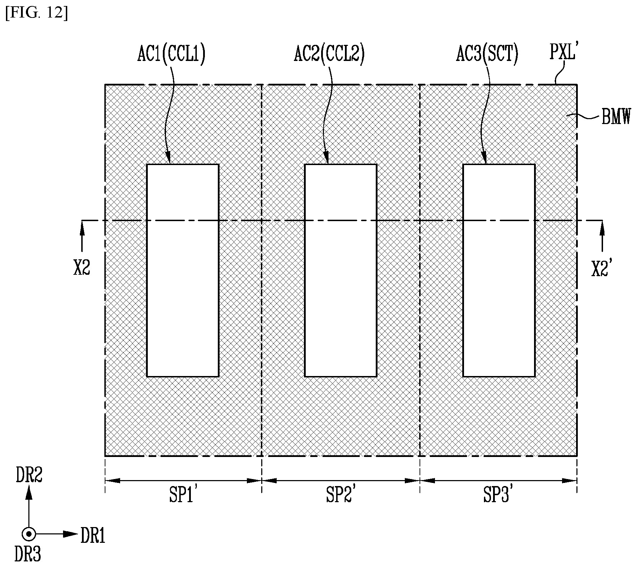

FIG. 12 is a schematic plan view for describing an embodiment of any one pixel among the pixels included in the display panel of FIG. 3.

Referring to FIG. 12, a pixel PXL' may include first to third sub-pixels SP1', SP2', and SP3'. The first to third sub-pixels SP1', SP2', and SP3' may be arranged in the first direction DR1. However, embodiments are not limited to the aforementioned example. The arrangement of the first to third sub-pixels SP1', SP2', and SP3' may be changed depending on the embodiments.

A partition wall structure BMW may be provided in the first to third sub-pixels SP1', SP2', and SP3'. The partition wall structure BMW may define first reception space AC1, second reception space AC2, and third reception space AC3.

The first reception space AC1 may overlap a first light emitting element of the first sub-pixel SP1'. A first color conversion layer CCL1 may be disposed in the first reception space AC1. Light emitted from the first light emitting element may be visible to the user of the display device DD via the first color conversion layer CCL1. The first color conversion layer CCL1 may include first color conversion particles. The first color conversion particles may convert the color of light emitted from the first light emitting element to red. Consequently, the first sub-pixel SP1' may be provided as a red sub-pixel.

The second reception space AC2 may overlap a second light emitting element of the second sub-pixel SP2'. A second color conversion layer CCL2 may be disposed in the second reception space AC2. Light emitted from the second light emitting element may be visible to the user of the display device DD via the second color conversion layer CCL2. The second color conversion layer CCL2 may include second color conversion particles. The second color conversion particles may convert the color of light emitted from the second light emitting element to green. Consequently, the second sub-pixel SP2' may be provided as a green sub-pixel.

The third reception space AC3 may overlap a third light emitting element of the third sub-pixel SP3'. A scattering layer SCL may be disposed in the third reception space AC3. Light emitted from the third light emitting element may be visible to the user of the display device DD via the scattering layer SCL. The scattering layer SCL may include scattering particles. The scattering particles may scatter light emitted from the third light emitting element. In embodiments, the third light emitting element may emit blue light. Consequently, the third sub-pixel SP3 may be provided as a blue sub-pixel.

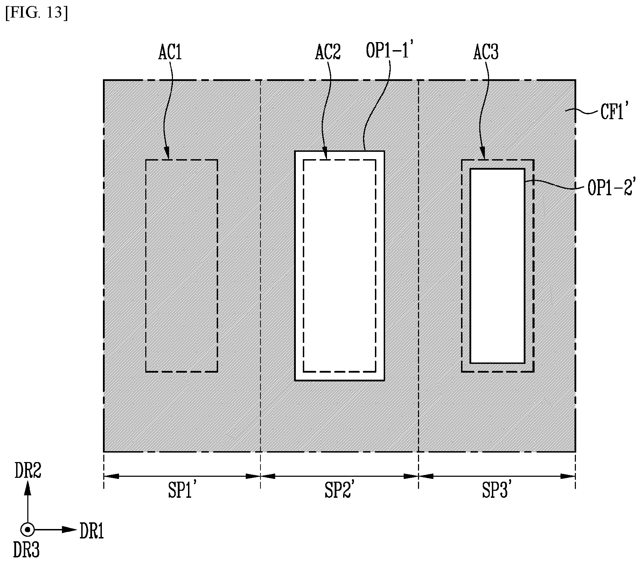

FIGS. 13 to 15 are schematic plan views for describing the color filter layer included in the pixel of FIG. 12.

Referring to FIGS. 12 and 13, a first color filter layer CF1' may be disposed on the partition wall structure BMW.

The first color filter layer CF1' may transmit light having a first wavelength range, and block light having a wavelength other than the first wavelength range. In embodiments, the first color filter layer CF1' may selectively transmit red light. For example, the first color filter layer CF1' may selectively transmit light having a wavelength equal to or greater than about 630 nm and equal to or less than about 780 nm.

As described above, the first sub-pixel SP1' may be provided as a red sub-pixel. In this case, the first color filter layer CF1' may overlap the first reception space AC1. Consequently, in the area where the first sub-pixel SP1' is provided, only red light may pass through the first color filter layer CF1 and be visible to the user of the display device DD.

The first color filter layer CF1' may define a 1-1-th opening OP1-1'. The 1-1-th opening OP1-1' may overlap the second reception space AC2. Therefore, light emitted from the second light emitting element of the second sub-pixel SP2' may not be substantially blocked by the first color filter layer CF1'. In embodiments, a perimeter of the 1-1-th opening OP1-1' may substantially overlap the perimeter of the second reception space AC2. Here, "substantially overlapping" may mean that, in a plan view, the surface area of an area of the 1-1-th opening OP1-1' that does not overlap the second reception space AC2 is about 10% or less of the surface area of the second reception space AC2, and by way of example about 5% or less.

The first color filter layer CF1' may define a 1-2-th opening OP1-2'. The 1-2-th opening OP1-2' may overlap the third reception space AC3. Therefore, light emitted from the third light emitting element of the third sub-pixel SP3' may not be substantially blocked by the first color filter layer CF1'. In embodiments, a perimeter of the 1-2-th opening OP1-2' may be enclosed by the perimeter of the third reception space AC3.

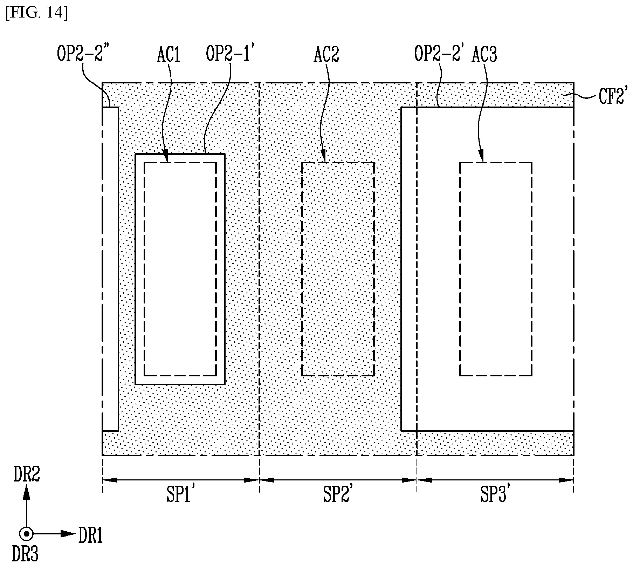

Referring to FIGS. 12 and 14, a second color filter layer CF2' may be disposed on the partition wall structure BMW.

The second color filter layer CF2' may transmit light having a second wavelength range, and block light having a wavelength other than the second wavelength range. In embodiments, the second color filter layer CF2' may selectively transmit green light. For example, the second color filter layer CF2' may selectively transmit light having a wavelength equal to or greater than about 500 nm and equal to or less than about 570 nm.

As described above, the second sub-pixel SP2' may be provided as a green sub-pixel. In this case, the second color filter layer CF2' may overlap the second reception space AC2. Consequently, in the area where the second sub-pixel SP2' is provided, only green light may pass through the second color filter layer CF2' and be visible to the user of the display device DD.

The second color filter layer CF2' may define a 2-1-th opening OP2-1'. The 2-1-th opening OP2-1' may overlap the first reception space AC1. Therefore, light emitted from the first light emitting element of the first sub-pixel SP1' may not be substantially blocked by the second color filter layer CF2'. In embodiments, a perimeter of the 2-1-th opening OP2-1' may substantially overlap the perimeter of the first reception space AC1. Here, "substantially overlapping" may mean that, in a plan view, the surface area of an area of the 2-1-th opening OP2-1' that does not overlap the first reception space AC1 is about 10% or less of the surface area of the first reception space AC1, and by way of example about 5% or less.

The second color filter layer CF2' may define a 2-2-th opening OP2-2'. The 2-2-th opening OP2-2' may overlap the third reception space AC3. Therefore, light emitted from the third light emitting element of the third sub-pixel SP3' may not be substantially blocked by the second color filter layer CF2'. In embodiments, a perimeter of the 2-2-th opening OP2-2' may enclose the perimeter of the third reception space AC3. In this case, the 2-2-th opening OP2-2' may partially overlap not only the third sub-pixel SP3' but also other sub-pixels (for example, the second sub-pixel SP2') adjacent to the third sub-pixel SP3'.

In embodiments, in the case where the pixel PXL' is arranged in the first direction DR1, a 2-2-th opening OP2-2" defined in a second color filter layer CF2' provided in another pixel adjacent to the pixel PXL' in a direction opposite to the first direction DR1 may partially overlap the first sub-pixel SP1' included in the pixel PXL'. In this case, in the pixel PXL' and the adjacent pixel, the 2-2-th openings OP2-2' and OP2-2" may be integral.

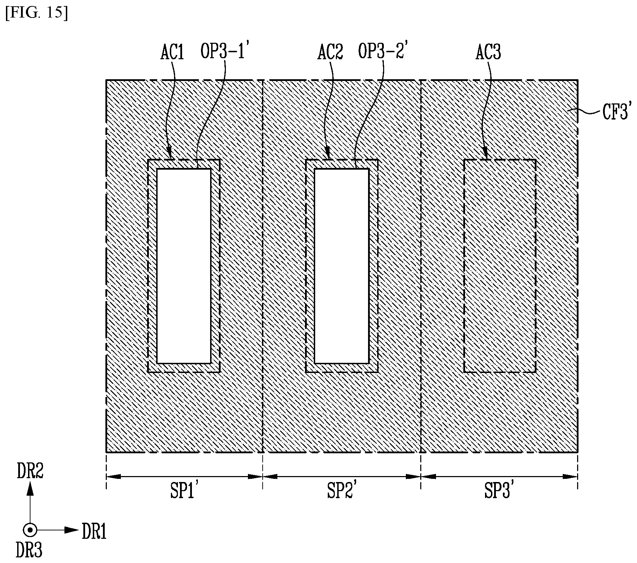

Referring to FIGS. 12 and 15, a third color filter layer CF3' may be disposed on the partition wall structure BMW.

The third color filter layer CF3' may transmit light having a third wavelength range, and block light having a wavelength other than the third wavelength range. In embodiments, the third color filter layer CF3' may selectively transmit blue light. For example, the third color filter layer CF3' may selectively transmit light having a wavelength equal to or greater than about 450 nm and equal to or less than about 495 nm.

As described above, the third sub-pixel SP3' may be provided as a blue sub-pixel. In this case, the third color filter layer CF3' may overlap the third reception space AC3. Consequently, in the area where the third sub-pixel SP3' is provided, only blue light may pass through the third color filter layer CF3' and be visible to the user of the display device DD.

The third color filter layer CF3' may define a 3-1-th opening OP3-1'. The 3-1-th opening OP3-1' may overlap the first reception space AC1. Therefore, light emitted from the first light emitting element of the first sub-pixel SP1' may not be substantially blocked by the third color filter layer CF3'. In embodiments, a perimeter of the 3-1-th opening OP3-1' may be enclosed by the perimeter of the first reception space AC1.

The third color filter layer CF3' may define a 3-2-th opening OP3-2'. The 3-2-th opening OP3-2' may overlap the second reception space AC2. Therefore, light emitted from the second light emitting element of the second sub-pixel SP2' may not be substantially blocked by the third color filter layer CF3'. In embodiments, a perimeter of the 3-2-th opening OP3-2' may be enclosed by the perimeter of the second reception space AC2.

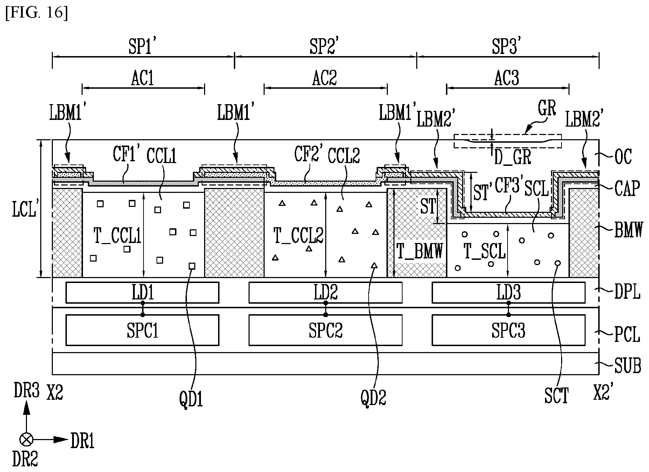

Referring again to FIGS. 12 to 15, the first to third color filter layers CF1', CF2', and CF3' may be sequentially stacked on the partition wall structure BMW. Hereinafter, the first to third color filter layers CF1', CF2', and CF3' that are sequentially stacked on the partition wall structure BMW will be described in more detail with reference to FIG. 16.

FIG. 16 is a schematic sectional view taken along line X2-X2' of FIG. 12.

Referring to FIGS. 12 to 16, the pixel circuit layer PCL, the display element layer DPL, and a light conversion layer LCL' may be sequentially disposed on the substrate SUB.

The pixel circuit layer PCL and the display element layer DPL can be described in the same manner as described with reference to FIG. 9. Therefore, redundant explanations may be omitted.

The light conversion layer LCL' may be disposed on the display element layer DPL. The light conversion layer LCL' may include the partition wall structure BMW, the first color conversion layer CCL1, the second color conversion layer CCL2, the scattering layer SCL, the capping layer CAP, the first color filter layer CF1', the second color filter layer CF2', the third color filter layer CF3', and an overcoating layer OC.

The partition wall structure BMW, the first color conversion layer CCL1, the second color conversion layer CCL2, and the scattering layer SCL can be described in the same manner as described with reference to FIG. 9. For example, a step ST defined between the upper surface of the scattering layer SCL and the upper surface of the partition wall structure BMW adjacent to the third reception space AC3 can be described in the same manner as described with reference to FIG. 9. Therefore, redundant explanations may be omitted.

The capping layer CAP can be described in the same manner as described with reference to FIGS. 9 to 11. For example, a step corresponding to the step ST may be defined in the capping layer CAP. Hereinafter, redundant explanations may be omitted.

The first to third color filter layers CF1', CF2', and CF3' may be disposed on the capping layer CAP. The openings OP1-1', OP1-2', OP2-1', OP2-2', OP2-2", OP3-1', and OP3-2' described with reference to FIGS. 13 to 15 may be defined in the first to third color filter layers CF1', CF2', and CF3'. Hence, in some areas, the first to third color filter layers CF1', CF2', and CF3' may overlap each other. In other some areas, the first to third color filter layers CF1', CF2', and CF3' may not overlap each other. In the case where the first to third color filter layers CF1', CF2', and CF3' overlap each other, the second color filter layer CF2' may be disposed on the first color filter layer CF1', and the third color filter layer CF3' may be disposed on the first and second color filter layers CF1' and CF2'.

The first color filter layer CF1' may overlap the first reception space AC1. In this case, the first color filter layer CF1' may extend to above the partition wall structure BMW adjacent to the first reception space AC1. Furthermore, the first color filter layer CF1' may be disposed on the partition wall structure BMW adjacent to the third reception space AC3.

The second color filter layer CF2' may overlap the second reception space AC2. In this case, the second color filter layer CF2' may extend to above the partition wall structure BMW adjacent to the second reception space AC2.

The third color filter layer CF3' may overlap the third reception space AC3. In this case, the third color filter layer CF3' may extend to above the partition wall structure BMW adjacent to the third reception space AC3. Furthermore, the third color filter layer CF3' may be disposed on the partition wall structure BMW adjacent to the first and second reception spaces AC1 and AC2. In this case, the first color filter layer CF1' or the first and second color filter layer2 CF1' and CF2' may be disposed under or below the third color filter layer CF3'.

On the partition wall structure BMW adjacent to the first and second reception spaces AC1 and AC2, the first to third color filter layers CF1', CF2', and CF3' may be sequentially stacked in the third direction DR3, thus defining a first light blocking stack LBM1'. On the partition wall structure BMW adjacent to the third reception space AC3, the first color filter layer CF1' and the third color filter layer CF3' may be sequentially stacked in the third direction DR3, thus defining a second light blocking stack LBM2'. The second light blocking stack LBM2' may not overlap the second color filter layer CF2'. As such, two different color filter layers or three difference color filter layers may be stacked, thus defining a light blocking stack for preventing light mixture between adjacent sub-pixels.

In an embodiment, the first light blocking stack LBM1' may extend from above the partition wall structure BMW to above the first color conversion layer CCL1, whereby the first light blocking stack LBM1' may partially overlap the first reception space AC1.

In an embodiment, the first light blocking stack LBM1' may extend from above the partition wall structure BMW to above the second color conversion layer CCL2, whereby the second light blocking stack LBM2' may partially overlap the second reception space AC2.

In an embodiment, the second light blocking stack LBM2' may extend from above the partition wall structure BMW to above the scattering layer SCL, whereby the second light blocking stack LBM2' may partially overlap the third reception space AC3. Therefore, the second light blocking stack LBM2' may cover the step ST defined between the upper surface of the scattering layer SCL and the upper surface of the partition wall structure BMW adjacent to the third reception space AC3.

In embodiments, a step ST' corresponding to the step ST may be defined between an upper surface of the second light blocking stack LBM2' disposed on the partition wall structure BMW adjacent to the third reception space AC3 and an upper surface of the third color filter layer CF3' that overlaps the scattering layer SCL. In the disclosure, the second light blocking stack LBM2' may have a structure in which two color filter layers (for example, the first color filter layer CF1' and the third color filter layer CF3') are stacked. Therefore, compared to the case where the second light blocking stack LBM2' has a structure in which three color filters (for example, the first to third color filter layers CF1', CF2', and CF3') are stacked, a thickness of the second light blocking stack LBM2' in the third direction DR3 may be relatively reduced. Consequently, the step ST' formed to correspond to the step ST may be relatively reduced.

In an embodiment, as illustrated in FIG. 16, the second reception space AC2 and the third reception space AC3 may be disposed adjacent to each other. In this case, in a cross-sectional view, in a first overlapping area that overlaps the partition wall structure BMW disposed between the second reception space AC2 and the third reception space AC3, the surface area of an area where the second light blocking stack LBM2' is disposed may be equal to or greater than the surface area of an area where the first light blocking stack LBM1' is disposed. For example, in a cross-sectional view, in the first overlapping area, the surface area of the area where the second light blocking stack LBM2' is disposed may be greater than the surface area of the area where the first light blocking stack LBM1' is disposed. For another example, the surface area of the area where the second light blocking stack LBM2' is disposed may be about 80% or more of the surface area of the area where the first light blocking stack LBM1' is disposed. In this case, the step ST' may be effectively reduced.

In an embodiment, unlike shown in FIGS. 12 and 16, the first sub-pixel SP1 may be disposed adjacent to the third sub-pixel SP3, and accordingly, the first reception space AC1 and the third reception space AC3 may be disposed adjacent to each other. In this case, in a cross-sectional view, in a second overlapping area that overlaps the partition wall structure BMW disposed between the first reception space AC1 and the third reception space AC3, the surface area of an area where the second light blocking stack LBM2' is disposed may be equal to or greater than the surface area of an area where the first light blocking stack LBM1' is disposed. For example, in a cross-sectional view, in the second overlapping area, the surface area of the area where the second light blocking stack LBM2' is disposed may be greater than the surface area of the area where the first light blocking stack LBM1' is disposed. For another example, the surface area of the area where the second light blocking stack LBM2' is disposed may be about 80% or more of the surface area of the area where the first light blocking stack LBM1' is disposed. In this case, the step ST' may be effectively reduced.

The overcoating layer OC may cover the entireties of the first to third color filter layers CF1', CF2', and CF3'. The overcoating layer OC may function to protect components disposed under or below the overcoating layer OC. In embodiments, the overcoating layer OC may include organic insulating material.

In embodiments, the window WD described with reference to FIG. 4 or a bonding (or adhesive) film formed to provide the window WD may be disposed on the overcoating layer OC. To this end, the overcoating layer OC may be required to have a substantially planar upper surface. For example, the step defined on the upper surface of the overcoating layer OC may be required to be equal to or less than about 0.5 micrometers. If the upper surface of the overcoating layer OC is not substantially planar, bonding defects (or adhesive defects) (for example, formation of air bubbles or the like) may occur between the overcoating layer OC and the window WD or between the overcoating layer OC and the film. In this case, the reliability of the window WD or the film may be reduced.

In an embodiment, in an area that overlaps the third reception space AC3, a groove GR that is concave in a direction toward the display element layer DPL may be defined in the overcoating layer OC. The groove GR may be formed by the step ST' derived from the step ST.

As described above, since the second light blocking stack LBM2' disposed on the partition wall structure BMW adjacent to the third reception space AC3 includes only two color filter layers (for example, the first color filter layer CF1' and the third color filter layer CF3'), the step ST' may be relatively reduced. Therefore, a depth D_GR of the groove GR formed by the step ST' may also be relatively reduced. For example, the depth D_GR of the groove GR may be less than about 0.5 micrometers. In this case, the reliability of the window WD or the film disposed on the overcoating layer OC may not be reduced.

While embodiments have been described above, those skilled in the art will appreciate that various modifications, additions and substitutions are possible, without departing from the scope and spirit of the disclosure and as claimed in the appended claims.

## Claims

1. A display device, comprising:
a partition wall structure that defines a first reception space, a second reception space and a third reception space through which an upper surface of a display element layer is exposed;
a color conversion layer including a first color conversion layer disposed in the first reception space, and a second color conversion layer disposed in the second reception space;
a scattering layer disposed in the third reception space, the scattering layer having a thickness less than each of a thickness of the first color conversion layer and a thickness of the second color conversion layer;
a capping layer that covers the partition wall structure, the color conversion layer, and the scattering layer; and
a color filter layer disposed on the capping layer, the color filter layer including a first color filter layer overlapping the first reception space, a second color filter layer overlapping the second reception space, and a third color filter layer overlapping the third reception space, wherein
a first light blocking stack formed by stacking the first color filter layer and the third color filter layer is disposed on the partition wall structure adjacent to the first reception space and the third reception space, and
a second light blocking stack formed by stacking the second color filter layer and the third color filter layer is disposed on the partition wall structure adjacent to the second reception space.

2. The display device according to claim 1, wherein the first light blocking stack does not overlap the second color filter layer.

3. The display device according to claim 1, wherein the second light blocking stack does not overlap the first color filter layer.

4. The display device according to claim 1, wherein a step is defined between an upper surface of the scattering layer and an upper surface of the partition wall structure adjacent to the third reception space.

5. The display device according to claim 4, wherein the step is about 20% or more and about 60% or less of a thickness of the partition wall structure.

6. The display device according to claim 1, further comprising:
an overcoating layer that covers the color filter layer.

7. The display device according to claim 6, wherein in an area that overlaps the third reception space, a groove that is concave in a direction toward the display element layer is defined in the overcoating layer.

8. The display device according to claim 7, wherein a depth of the groove is less than about 0.5 micrometers.

9. The display device according to claim 1, wherein the thickness of the first color conversion layer and the thickness of the second color conversion layer are about 85% or more of a thickness of the partition wall structure.

10. The display device according to claim 1, wherein the capping layer includes a material having a refractive index of about 1.3 or less.

11. The display device according to claim 1, wherein
the first color conversion layer includes a first color conversion particle,
the second color conversion layer includes a second color conversion particle, and
the scattering layer includes a scattering particle.

12. The display device according to claim 1, wherein the display element layer includes:
a first light emitting element overlapping the first reception space;
a second light emitting element overlapping the second reception space; and
a third light emitting element overlapping the third reception space.

13. A display device, comprising:
a partition wall structure that defines a first reception space, a second reception space and a third reception space through which an upper surface of a display element layer is exposed;
a color conversion layer including a first color conversion layer disposed in the first reception space, and a second color conversion layer disposed in the second reception space;
a scattering layer disposed in the third reception space, the scattering layer having a thickness less than each of a thickness of the first color conversion layer and a thickness of the second color conversion layer;
a capping layer that covers the partition wall structure, the color conversion layer, and the scattering layer; and
a color filter layer disposed on the capping layer, the color filter layer including a first color filter layer overlapping the first reception space, a second color filter layer overlapping the second reception space, and a third color filter layer overlapping the third reception space, wherein
a first light blocking stack formed by stacking the first color filter layer, the second color filter layer, and the third color filter layer is disposed on the partition wall structure adjacent to the first reception space and the second reception space, and
a second light blocking stack formed by stacking the first color filter layer and the third color filter layer is disposed on the partition wall structure adjacent to the third reception space.

14. The display device according to claim 13, wherein the second light blocking stack does not overlap the second color filter layer.

15. The display device according to claim 13, wherein a step is defined between an upper surface of the scattering layer and an upper surface of the partition wall structure adjacent to the third reception space.

16. The display device according to claim 15, wherein the step is about 20% or more and about 60% or less of a thickness of the partition wall structure.

17. The display device according to claim 13, further comprising:
an overcoating layer that covers the color filter layer.

18. The display device according to claim 17, wherein in an area that overlaps the third reception space, a groove that is concave in a direction toward the display element layer is defined in the overcoating layer.

19. The display device according to claim 18, wherein a depth of the groove is less than about 0.5 micrometers.

20. The display device according to claim 13, wherein the thickness of the first color conversion layer and the thickness of the second color conversion layer are each about 85% or more of a thickness of the partition wall structure.

21. The display device according to claim 13, wherein the capping layer includes a material having a refractive index of about 1.3 or less.

22. The display device according to claim 13, wherein in an area that overlaps the partition wall structure disposed between the first reception space and the third reception space, a surface area of an area where the second light blocking stack is disposed is greater than a surface area of an area where the first light blocking stack is disposed in a cross-sectional view.

23. The display device according to claim 13, wherein in an area that overlaps the partition wall structure disposed between the second reception space and the third reception space, a surface area of an area where the second light blocking stack is disposed is greater than a surface area of an area where the first light blocking stack is disposed in a cross-sectional view.
